# EUROPEAN PATENT APPLICATION

(11) **EP 4 815 308 A1**
(43) Date of publication of application: **30.09.2026**
(21) Application number: 25166529.5
(22) Date of filing: 27.03.2025
(51) Int. Cl.: H03K 17/18, H02M 1/00, H03K 17/691

(54) **GATE DRIVER ARRANGEMENT**

(71) Applicant: Reinhausen GmbH, 93059 Regensburg (DE)
(72) Inventor: Snook, Mark, Cambridge, CB24 9AD (GB); LEEDHAM, Robert, John, Cambridge, CB1 8SJ (GB)

(57) **Abstract**

The disclosure relates to a gate driver arrangement (100) comprising: a controller (110); a gate drive circuit (210) for driving a gate (211) of a transistor (U1); and a transformer (T1) being electrically arranged between the controller (110) and the gate drive circuit (210), the transformer (T1) being configured for galvanically separating the controller (110) from the gate drive circuit (210); wherein the controller (110) is configured to transmit an electrical power signal to the gate drive circuit (210) via the transformer (T1) within a first time interval; and wherein the gate drive circuit (210) is configured to transmit a data signal to the controller (110) via the transformer (T1) within a second time interval, wherein the data signal contains data, and wherein the first time interval and the second time interval do not overlap. The disclosure further relates to a method for operating a gate driver arrangement and a Modular Multilevel Converter comprising such gate driver arrangement.

## Description

### TECHNICAL FIELD

The disclosure relates to the field of electrical power transfer and Modular Multilevel Converter (MMC) design. In particular, the disclosure relates to a gate driver arrangement, a method for operating a gate driver arrangement and an MMC comprising such gate driver arrangement. Specifically, the disclosure relates to transformer communications and power transfer.

### BACKGROUND

A gate drive is applied for galvanically isolated transmission of command and status feedback signals between a microprocessor (primary side) and a power semiconductor (secondary side). Conventional gate drives have a transformer for unidirectional power transfer over an isolation barrier. Separately there is a means for sending data to the gate drive, for example to instruct it to turn the power switch (e.g. IGBT or MOSFET) that it is driving, on or off. The gate drive typically returns data to the controller, for example, this might be an acknowledgement signal that the switching signal was received, a fault status, or some measurement made by the gate drive such as temperature. This bi-directional data transfer must also be across an isolation barrier due to the potential difference of the controller and the gate drive. This isolated communication path is typically implemented using a separate mechanism to the power transfer. It could be implemented using a different kind of transformer (signal or pulse transformer), a fibre-optic link or opto-coupler, or a digital isolator (there are capacitive and inductive types of digital isolator). All of these isolated data communication implementations are uni-directional, so there needs to be two channels per gate drive, one from controller to gate drive and another in the reverse direction.

Using such gate drive in MMC cell design is rather costly and wiring is complicated, because in the conventional design one power cable and a pair of fibre-optic cables are required for each gate drive, of which there are four in a full bridge cell. Moreover, there is a minimum bend radius for fibre-optic cables and routing is challenging.

### SUMMARY

It is the object of this disclosure to provide a solution for a gate drive in MMC cell design at reduced costs and simplified wiring inside the MMC cell.

This object is achieved by the features of the independent claims. Further implementation forms are apparent from the dependent claims, the description and the figures.

To overcome the above-described problems the disclosure presents a new concept for transformer communications and power transfer.

This new concept is to combine isolated power and bi-directional data transfer into a single pair of wires and a single transformer which reduces part count and therefore increases reliability. The lifetime of such a solution can thus be improved compared to optical isolation and this is important for the field of grid connected power electronics which are expected to be installed for 20 years or more. The inventive concept is based on the fact, that there are some unique conditions for the MMC cell gate drive that are not necessarily applicable in other applications of gate drives. For this application, bi-directional data transfer at a relatively low data rate (e.g. one bit every 5us) is sufficient and the power transfer is of the order of 2-5W. Compared to the conventional data communication designs where a phase-locked loop may be used to synchronise the receiver to the transmitter and recover a clock signal, this is not necessary in the inventive concept as described in this disclosure.

The technical advantages of this new approach are lower cost, simpler and more compact gate drive design, reduced number of components. The need to route separate power and signal cables (electrical or fibre-optic) is removed which make assembly and maintenance of the cell easier.

The cost benefit is both initial capital cost and operating cost due to improved lifetime. There is the initial cost of the gate drive and the controller that connects to it, and reduced cost of cabling. Because the solution uses fewer parts the reliability can be improved and therefore the need to replace parts and cost of maintenance are reduced.

Embodiments of the disclosure describe an aspect of the MMC cell gate drive design. It details a mechanism for transferring power and bi-directional data over an isolation barrier using a single transformer. The solution described herein is most relevant for gate drives as there is a large potential difference (voltage) between the controller and the gate drive and that voltage is changing rapidly.

The idea presented in this disclosure can also be extended to a remote sensor if the sensor is located in such a place that it would experience a high potential and where there must be galvanic isolation between the sensor and the equipment it is attached to for power and data transfer.

According to a first aspect, the disclosure relates to a gate driver arrangement comprising: a controller; a gate drive circuit for driving a gate of a transistor; and a transformer being electrically arranged between the controller and the gate drive circuit, the transformer being configured for galvanically separating the controller from the gate drive circuit; wherein the controller is configured to transmit an electrical power signal to the gate drive circuit via the transformer within a first time interval; and wherein the gate drive circuit is configured to transmit a data signal to the controller via the transformer within a second time interval, wherein the data signal contains data, and wherein the first time interval and the second time interval do not overlap.

Such a gate driver arrangement allows to implement isolated power and bi-directional data transfer into a single pair of wires and a single transformer, thereby reducing part count and therefore increasing reliability. The lifetime of such a gate driver arrangement is thus improved compared to optical isolation.

In an exemplary implementation of the gate driver arrangement, the data indicates an operation status of the gate drive circuit.

By this data which is received from the gate drive circuit when the transformer is driven in reverse direction, the controller can monitor the state of the gate drive circuit.

In an exemplary implementation of the gate driver arrangement, the controller is configured to transmit a control signal to the gate drive circuit within the first time interval, in particular within a third time interval which is within the first time interval.

The controller can thus transmit the control signal to the gate drive circuit within the first time interval, i.e., when the transformer is driven in forward direction. The control signal can for example control the gate drive circuit based on the received data which indicates the state of the gate drive circuit. For example, when the data indicates no fault, the control signal can drive the gate drive controller to operate in normal operation mode. In an exemplary implementation, if the gate drive detects a fault, the IGBT is turned off and the fault signal is sent to the controller. The gate drive may wait to see the control signal go low (as an acknowledgement of the fault) before allowing the IGBT to be turned on again after a fault timeout period.

In an exemplary implementation of the gate driver arrangement, the gate drive circuit is configured to operate according to the received control signal.

By such feature, the gate drive circuit can be controlled by the controller over the isolation barrier.

In an exemplary implementation of the gate driver arrangement, the controller is configured to use the electric power signal as a carrier of the control signal, in particular to modulate the electrical power signal with the control signal.

This allows an efficient transmission of the control signal to the gate drive circuit over the isolation barrier.

In an exemplary implementation of the gate driver arrangement, the gate drive circuit is configured to retrieve the control signal, in particular to retrieve the control signal from the received electrical power signal or to demodulate the received electrical power signal to obtain the control signal.

This feature provides an efficient mechanism for retrieving or demodulating the control signal from the received electrical power signal. No extra wiring such as optical cables are required for retrieving the control signal. This eliminates the need for a pair of fiber optic cables and associated transmitter receiver parts per gate drive, with considerable cost and space savings for both the gate drive and the controller.

In an exemplary implementation of the gate driver arrangement, the gate driver arrangement is used to drive a single transistor, in particular a transistor being part of a half-bridge-converter or a full-bridge converter.

Such gate driver arrangement can be universally applied for driving any transistor and any half-bridge or full-bridge converter.

In an exemplary implementation of the gate driver arrangement, the bridge converter comprises the transistor with the gate, wherein the transistor is configured to form a power switch; and the gate drive circuit is configured to apply a gate drive voltage to the gate of the transistor in order to switch the transistor into a conducting state; wherein the gate drive voltage is based on the electrical power signal received from the controller.

Such gate driver arrangement can be flexible used for driving the gate of a transistor or power switch. The advantages of such gate driver arrangement over the fiber-optic solution are already described above.

In an exemplary implementation of the gate driver arrangement, the data signal comprises a status of the transistor including any faults detected and/or a measurement signal about a state of the transistor, in particular a voltage and/or a temperature of the power transistor.

This status of the transistor can be advantageously exploited by the controller to control the gate drive circuit. For example, when the temperature is above a threshold, the gate drive circuit can be switched off for some time. The most common reason for a fault is that the IGBT has failed or the converter is experiencing an unusual condition (such as excessive current).

In an exemplary implementation of the gate driver arrangement, the gate driver arrangement comprises: first and second switches; a first switch control circuit for controlling switching of the first and second switches by the controller; third and fourth switches; a second switch control circuit for controlling switching of the third and fourth switches by the gate drive circuit; wherein the first and second switch control circuits are configured to enable the transmission of the electrical power signal to the gate drive circuit via the transformer by alternately switching the first and second switches while simultaneously keeping open the third and fourth switches.

These components allow to drive the transformer in forward direction for power transfer and communication and in reverse direction for receiving the data from the gate drive circuit.

In an exemplary implementation, once the communication is established, the SW3 and SW4 switches can always be driven synchronously selectively, thus they can be used as "synchronous rectifiers"; they would take over from the diodes, improving the power supply efficiency.

In an exemplary implementation of the gate driver arrangement, the first and second switch control circuits are configured to enable the transmission of the data signal to the controller via the transformer by opening the first and second switches and selectively activating the third and fourth switches.

This allows to actively drive the transformer by the controller and the gate drive circuit by respectively controlling the first to fourth switches with their respective switch control circuits.

In an exemplary implementation of the gate driver arrangement, the controller is configured to transmit a synchronization pulse to the gate drive circuit, the synchronization pulse synchronizing the gate drive circuit to transmit the data signal to the controller via the transformer within the second time interval.

The synchronization pulse allows to synchronize forward and reverse data transmission over the transformer for providing the control signal to the gate drive circuit and for providing the data signal back to the controller.

In an exemplary implementation of the gate driver arrangement, an electrical signal transmitted via the transformer has a duty cycle between 48% and 52%, preferably 50% duty cycle.

Then, the voltage on the line has a duty cycle of about 50%, i.e. the total time high and low is balanced for one time interval. This fulfills the requirement to prevent the transformer core from saturation.

In an exemplary implementation of the gate driver arrangement, the gate driver arrangement comprises: two rectifier diodes configured to rectify a voltage received by the transformer for the transmission of the power signal to the gate drive circuit.

The rectifier diodes allow to rectify the incoming square wave to produce a DC voltage just less than the primary power supply, e.g. 24V. The DC voltage can then be provided to the switch control on gate drive side.

In an exemplary implementation of the gate driver arrangement, the gate driver arrangement comprises: an electrically conducting connection connecting the controller and the transformer, in particular a twisted-pair cable, wherein the controller is configured to transmit the electrical power signal over the electrically conducting connection, and wherein the gate drive circuit is configured to transmit the data signal to the controller over the electrically conducting connection.

This design provides the above-described advantages with respect to combination of isolated power and bi-directional data transfer as well as lifetime.

According to a second aspect, the disclosure relates to a method for operating a gate driver arrangement, the gate driver arrangement comprising: a controller; and a gate drive circuit, wherein a transformer is electrically arranged between the controller and the gate drive circuit, the transformer galvanically separating the controller from the gate drive circuit, the method comprising: transmitting, by the controller, an electrical power signal to the gate drive circuit via the transformer within a first time interval; and transmitting, by the gate drive circuit, a data signal to the controller via the transformer within a second time interval, wherein the data signal contains data, and wherein the first time interval and the second time interval do not overlap.

Such a method for operating a gate driver arrangement allows to combine isolated power and bi-directional data transfer by using a single pair of wires and a single transformer, thereby reducing part count and increasing reliability as mentioned above.

According to a third aspect, the disclosure relates to a Modular Multilevel Converter, MMC, comprising: a plurality of gate driver arrangements according to the first aspect as described above, the plurality of gate driver arrangements being electrically arranged in parallel or in series.

Such an MMC with gate driver arrangement described above provides a solution for a gate drive in MMC cell design at reduced costs and simplified wiring inside the MMC cell.

### BRIEF DESCRIPTION OF THE DRAWINGS

Further examples will be described with respect to the following figures, in which:
Fig. 1 shows a circuit diagram of a gate driver arrangement 100 according to the disclosure;
Fig. 2 shows a timing diagram 200 illustrating exemplary timing waveforms of specific signals during operation of the gate driver arrangement 100;
Fig. 3 shows a timing diagram 300 illustrating exemplary timing waveforms of specific signals during operation of the gate driver arrangement 100;
Fig. 4 shows another timing diagram 400 illustrating exemplary timing waveforms of specific signals during operation of the gate driver arrangement 100;
Fig. 5 shows another timing diagram 500 illustrating exemplary timing waveforms of a specific implementation of the gate driver arrangement 100; and
Fig. 6 shows a schematic diagram illustrating a method 600 for operating a gate driver arrangement according to the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. Further, it is understood that the features of the various exemplary aspects described herein may be combined with each other, unless specifically noted otherwise.

In this disclosure, gate drives, gate drive circuits and gate drive transformers are described.

Current through a transistor, e.g., MOSFET between drain and source is controlled by a drive voltage applied to the MOSFET gate. In switching power supplies a pulsed gate drive voltage turns the drain-source current on and off, operating the MOSFET as a current switch. In embodiments of the disclosure, the transformer is between the controller and the gate drive and the gate drive is at the same potential as the MOSFET drain.

The following embodiments are related to gate drive arrangements and Modular Multilevel Converters (MMCs).

The Modular Multilevel Converter (MMC) is the standard approach within the power converter industry to realize High Voltage Direct Current (HVDC) converters for use in power transmission. They are being widely adopted, too, for use in medium-voltage (MV) drive applications, including power distribution applications. An MMC converter consists of multiple cells connected in series to form a phase arm; one or two of these may be used per phase, depending on the application. Traditional MMC cells are half-bridge or full-bridge; half-bridge cells block voltage in one direction while full-bridge cells block voltage in both directions. In a family of production converters, there may be a range of overall converter current and voltage ratings, to suit a wide range of applications. Accommodating different voltage ratings is straightforward given that many cells are placed in series to achieve the required voltage rating; however, the current rating of the converter typically falls within the current rating of a single cell.

The simple topology of the full-bridge cell allows a switching sequence to generate three different levels of output voltage. By summing the individual output voltages of the full-bridge cells in a Single-Delta Bridge Cell (SDBC-MMC) configuration, for example, the converter provides a variable output voltage with a high dynamic range at the connection point.

The connection of the full-bridge cells in an SDBC arrangement allows to realize a wide range of applications, such as systems for dynamic voltage stabilization in HV/MV distribution systems, systems for dynamic reactive power compensation or systems for flicker mitigation. A large number of individual cells can be combined to form a high-power converter, e.g., for the typical voltage levels of 12kV (e.g., by 12 cells in series per phase leg), 24kV (e.g., by 24 cells in series per phase leg) and 36kV (e.g., by 36 cells in series per phase leg).

High power (e.g., 3300V, 500A+) IGBT gate drive circuit boards are available in the public domain. Commercial board level solutions are available above 1200V as well as chip level solutions from multiple vendors at lower power levels.

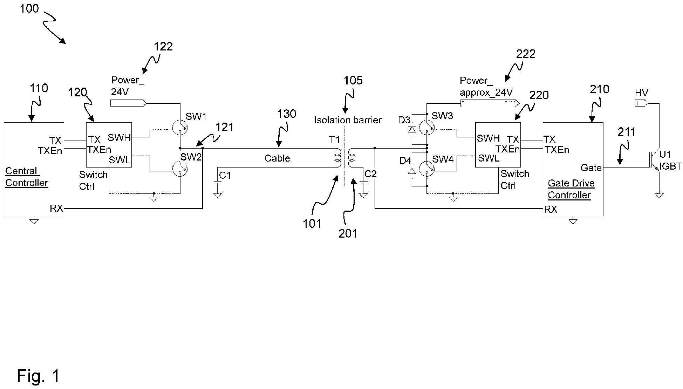

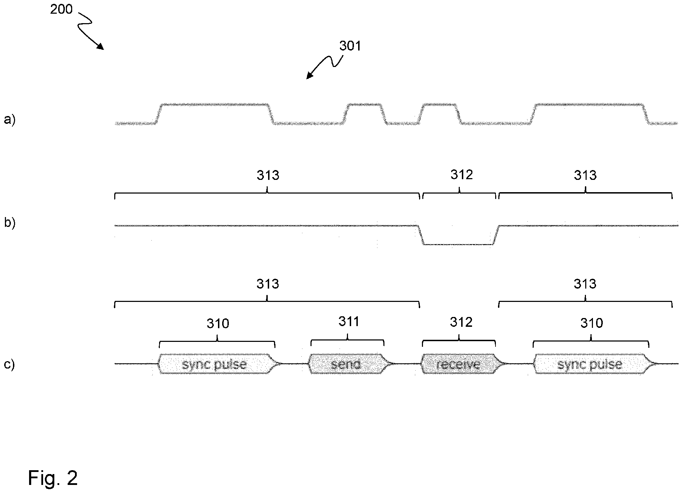

Fig. 1 shows a circuit diagram of a gate driver arrangement 100 according to the disclosure. The gate driver arrangement 100 comprises: a controller 110 (also referred to in Figure 1 as central controller); a gate drive circuit 210 (also referred to in Figure 1 as gate drive controller) for driving a gate 211 of a transistor U1, e.g., an IGBT; and a transformer T1 which is electrically arranged between the controller 110 and the gate drive circuit 210. The transformer T1 is configured for galvanically separating the controller 110 from the gate drive circuit 210. The controller 110 is configured to transmit an electrical power signal 301 as exemplarily shown in Figure 2 to the gate drive circuit 210 via the transformer T1 within a first time interval 313 as exemplarily shown in Figure 2; and the gate drive circuit 210 is configured to transmit a data signal to the controller 110 via the transformer T1 within a second time interval 312 as exemplarily shown in Figure 2 which does not overlap with the first time interval 313. The data signal contains data.

Exemplary timing diagrams of the gate driver arrangement 100 are shown in Figures 2 to 6 and explained below.

The data may indicate an operation status of the gate drive circuit 210.

The controller 110 may be configured to transmit a control signal to the gate drive circuit 210 within the first time interval 313, in particular within a third time interval 311 as exemplarily shown in Figure 2 which is within the first time interval 313.

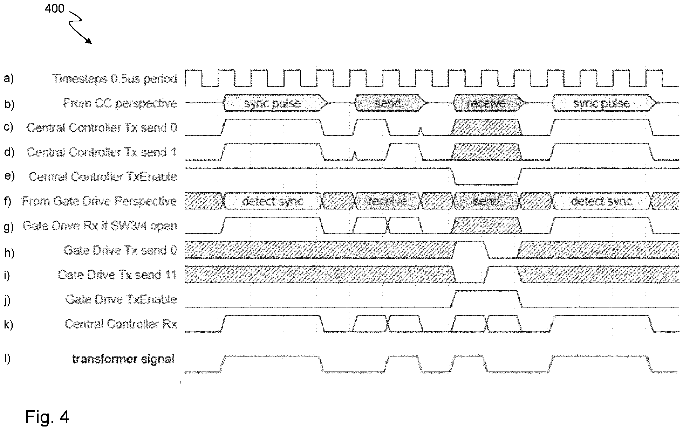

The first time interval 313 may correspond to timing waveform e) shown in Figure 4, i.e., it may correspond to the times when the central controller 110 is set to TxEnable (TxEn). The second time interval 312 may also correspond to the timing waveform e) shown in Figure 4 and here it may correspond to the times when the central controller 110 is set to TxDisable or not TxEnable. This corresponds to the times when the central controller 110 is allowed to receive data (and not allowed to send) as indicated in the timing waveform b) shown in Figure 4 by the timing interval "receive". The third time interval 311 may correspond to the times when the central controller 110 is allowed to send data as indicated in the timing waveform b) shown in Figure 4 by the timing interval "send".

The gate drive circuit 210 may be configured to operate according to the received control signal.

The controller 110 may be configured to use the electric power signal 301 as a carrier of the control signal, in particular to modulate the electrical power signal with the control signal.

The gate drive circuit 210 may be configured to retrieve the control signal, in particular to retrieve the control signal from the received electrical power signal or to demodulate the received electrical power signal to obtain the control signal.

The gate driver arrangement 100 may be used to drive a single transistor such as U1, in particular a transistor being part of a half-bridge-converter or a full-bridge converter.

The (half or full) bridge converter may comprise the transistor U1 with the gate 211. This transistor U1 may be configured to form a power switch. The gate drive circuit 210 may be configured to apply a gate drive voltage to the gate 211 of the transistor U1 in order to switch the transistor U1 into a conducting state. The gate drive voltage may be based on the electrical power signal received from the controller 110.

U1 can be a transistor such as a MOSFET or BJT or IGBT, for example, but the power plus data transfer is also useful for other switches such as thyristors where data back is wanted.

The data signal may comprise a status of the transistor U1 including any faults detected and/or a measurement signal about a state of the transistor U1, for example a voltage and/or a temperature of the transistor U1.

As shown in Figure 1, the gate driver arrangement 100 may comprise: first and second switches SW1, SW2; a first switch control circuit 120 for controlling switching of the first and second switches SW1, SW2 by the controller 110; third and fourth switches SW3, SW4; and a second switch control circuit 220 for controlling switching of the third and fourth switches SW3, SW4 by the gate drive circuit 210. The first and second switch control circuits 120, 220 may be configured to enable the transmission of the electrical power signal to the gate drive circuit 210 via the transformer T1 by alternately switching the first and second switches SW1, SW2 while simultaneously opening the third and fourth switches SW3, SW4.

The first and second switch control circuits 120, 220 may be configured to enable the transmission of the data signal to the controller 110 via the transformer T1 by opening the first and second switches SW1, SW2 and selectively activating the third and fourth switches SW3, SW4.

The controller 110 may be configured to transmit a synchronization pulse 310 as exemplarily shown in Figure 2 to the gate drive circuit 210. The synchronization pulse 310 is synchronizing the gate drive circuit 210 to transmit the data signal to the controller 110 via the transformer T1 within the second time interval 312.

The synchronization pulse 310 may correspond to the timing interval "sync pulse" as shown in timing waveform b) in Figure 4.

An electrical signal transmitted via the transformer T1 may have a duty cycle between 48% and 52%, for example, preferably a 50% duty cycle. Such an electrical signal transmitted via the transformer T1 is exemplarily shown by the timing waveform I) of Figure 4.

The gate driver arrangement 100 may comprise two rectifier diodes D3, D4 configured to rectify a voltage received by the transformer T1 for the transmission of the power signal to the gate drive circuit 210.

The gate driver arrangement 100 may comprise: an electrically conducting connection 130 connecting the controller 110 and the transformer T1, for example a twisted-pair cable or any other kind of cable. The controller 110 may be configured to transmit the electrical power signal over the electrically conducting connection 130, and the gate drive circuit 210 may be configured to transmit the data signal to the controller 110 over the electrically conducting connection 130.

A Modular Multilevel Converter (MMC) may be formed by a plurality of gate driver arrangements 100 as described above. The plurality of gate driver arrangements 100 may be electrically arranged in parallel or in series.

In the following, operation of the gate driver arrangement 100 is described in more detail.

If the central controller 110 is switching SW1 and SW2, and the gate drive controller 210 does nothing, so SW3 and SW4 are open, then power will be transferred to the gate drive and the diodes D3 and D4 will rectify the incoming square wave to produce a DC voltage just less than the primary power supply 122 (e.g. 24V). When the central controller 110 TxEnable (TxEn) is low, SW1 and SW2 are open, and the gate drive controller 210 TxEnable (TxEn) can be driven high, so that SW3 and SW4 control the transformer T1.

When SW1 is closed SW2 is open and vice versa. Similarly, when SW3 is closed, SW4 is open. Only one side can drive the transformer T1 at any one time, so if either SW1 or SW2 are closed, then SW3 and SW4 must both be open. If either SW3 or SW4 are closed, then both SW1 and SW2 must be open.

Both sides monitor the transformer voltage, see the RX input to both controllers 110, 210. These signals are identical so both sides see the same waveform, and thus, the synchronization pulse sent from the central controller 110 is used by the gate drive controller 210 so that it knows when it is safe to drive TxEnable (TxEn), and therefore, enable data transfer in the reverse direction.

The transformer T1 isolates the gate drive 210 from the central controller 110. The ground reference at the gate drive end of the cable 130 is therefore isolated from the ground at the central controller 110. This means there can be a large potential difference between them. The gate drive 210 controls a power switch U1 which can be an IGBT or MOSFET and when that switch U1 turns on and off, there is a rapid change in potential seen between the primary side 101 and secondary side 201 of the transformer T1. The key to an error free communication system is that the data pulses can be discriminated from any "noise" caused by this rapid change in potential.

In the following, an exemplary implementation of the gate driver arrangement 100 is described.

The controller 110 generates an 24V peak-peak AC signal, which is carried over a twisted pair of cables 130 to the gate drive. This signal is powerful enough to carry sufficient power for the gate drive and has a complex structure which carries data both to and from to the gate drive itself. The 24V AC signal is designed to be simple to pass over a transformer isolation barrier 105, which gives the necessary isolation for the gate drive. The transformer T1 chosen in this exemplary implementation is a simple toroid with two off 8 turn winds of 1000V insulated wire. It is also possible to use standard potted transformers which are designed to be used in the 100kHz - 1MHz range.

As standard an RJ45 connector can be used which has 8 cables, comprising of 4 sets of 2 twisted pairs. These are used as two parallel sets, giving redundancy, while allowing the one cable to power and control a gate drive half bridge. This is convenient, as gate drives now commonly are used as half bridges (two gate drives together to drive two IGBTs in one package).

This relies upon a known timing interval gate drive signal, which is always present. The gate drive state can only be altered a maximum of once per timing interval. The transformer T1 used is a simple part, which can be actively driven by the (cell) Controller 110 or Gate Drive 210. Most of the time the transformer T1 is driven actively by the Controller 110 - it is only during this period that power is transferred to the Gate Drive. For a brief period the transformer T1 is driven in reverse - the state of it is set by the gate drive 210 - it is important that the Controller 110 does not attempt to drive at the same time as this would result in a short circuit, wasting power.

A simplified transmitter and receiver structure is shown in Figure 1. On the left of the schematic is the circuitry implemented in the Controller 110, then a twisted pair cable assembly 130 to the Gate Drive, in which is the isolation barrier 105. The transformer T1 can be driven in either direction - this is indicated by the "TXEn" signals in left and right switch controls 120, 220 in the schematic.

The gate driver arrangement 100 can be implemented in an exemplary implementation by a two-channel gate drive. The transformers, one for each channel can be implemented by toroids made from ferrite material and with wires. The wires have high voltage insulation to withstand the potential difference that can exist between the primary and the secondary side of the transformer T1.

Wire pairs between the toroids can route into a single connector so that a standard twisted pair cable can be used between the gate drive and the central controller 110. The wire pairs can route to the gate drive circuit board which can be connected to the IGBT modules, e.g., by using screws. The gate drive controller 210 can be implemented, for example, in a small microcontroller.

Fig. 2 shows a timing diagram 200 illustrating exemplary timing waveforms of specific signals during operation of the gate driver arrangement 100.

Waveform a) corresponds to the electric power signal 301 which is the transformer signal, i.e., the signal transmitted over transformer T1.

Waveform b) corresponds to TxEnable (TxEn) signal of central controller 110 of Figure 1. The Enabling section (TxEn=1) corresponds to the first time interval 313 during which the electrical power signal 301 is transmitted via the transformer T1 from controller 110 to gate drive circuit 210. The disabling section (TxEn=0) corresponds to the second time interval 312 during which the data signal is transmitted via the transformer T1 from gate drive circuit 210 to controller 110. The disabling section (TxEn=0).

Waveform c) illustrates the timing of the synchronization pulse 310 within the first time interval 313, the control signal ("send" for controller 110) within the third time interval 311 and the data signal ("receive" for gate drive circuit 210) during the second time interval 312.

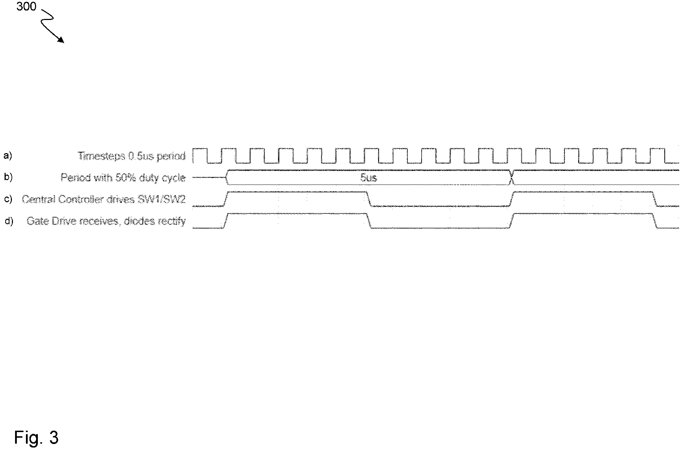

Fig. 3 shows a timing diagram 300 illustrating exemplary timing waveforms of specific signals during operation of the gate driver arrangement 100. The timing of 5us periods in the Figures is an example and what can be used in an example implementation. However, this time period can be increased or decreased depending on other aspects of the circuit.

To transfer power across the transformer T1 a square wave as shown by waveform a) in the timing diagram 300 is all that is required. Transformers block DC and only transfer power through an alternating magnetic field, hence the central controller 110 implements a switching circuit to generate AC from the 24V DC (122), and the gate drive has a rectifier (see diodes D3, D4 in Figure 1). If a transformer has a DC voltage applied it will create a DC offset current through it, potentially causing the magnetic material to operate outside of its linear region.

Waveform b) shows an exemplary period with 50% duty cycle. Waveform c) shows the timing waveform when central controller 110 drives SW1/SW2. Waveform d) shows the timing waveform when gate drive 210 receives and diodes D3, D4 rectify.

Fig. 4 shows another timing diagram 400 illustrating exemplary timing waveforms of specific signals during operation of the gate driver arrangement 100.

The synchronisation pulse ("sync pulse" in waveform b) repeats every 5us in this example, so the total number of high pulses and low pulses in a 5us period is always 5. Therefore, on average the power transfer is the same as in the simplified system, and the mean voltage presented to the transformer (T1 shown in Figure 1) is still zero, so the core of it operates in its linear region.

The repetition rate of 5us or 200kHz was chosen to match the capabilities of the ferrite core that is used to implement the transformer. In theory the size can be reduced and frequency of operation can be increased, however there is a limit based on the thickness of the wire insulation and the distance required between the primary 101 and secondary 201 terminals of the transformer T1 (see Figure 1).

The data transfer is described as half-duplex because only one side of the transformer can be driven at any time. The handover from send ("send" in waveform b) to receive ("receive" in waveform b) is coordinated by the synchronisation pulse ("sync pulse" in waveform b) which is generated at the central controller 110 (see Figure 1).

Whilst only one bit of information is transferred in every 5us period, over a longer time period a packet, frame or datagram can be transferred in both directions. A protocol is needed to signify the start of a new frame and encoding schemes such as HDLC can be used to encode the data and provide a checksum for reliable communication.

In the exemplary implementation shown in Figure 1 the information transmitted from the central controller 110 to the gate drive 210 is the IGBT switch state, either on or off with no frame format. The data transferred from the gate drive 210 back to the central controller 110 is a frame containing the status of the IGBT including any faults detected, and measurements such as gate drive voltages and temperatures.

An exemplary 5us packet structure is shown in Figure 4 used to transmit data. Many other structures can also be used as well. This one involves a unique wide synchronisation pulse, followed by two shorter pulses - the simple sync pulse allows for fast synchronisation of the gate drive 210 to the controller 110 (see Figure 1). One of the short pulses is from the Controller 110, the other is from the Gate drive 210. Each of these short pulses can be in one of two timings, indicating a "0" or a "1" data bit to be transferred, and in all cases the transformer T1 operates overall at 50% duty for good utilisation such that it does not saturate the core. In addition, the 3 pulses are always unique, never joining together, such that they are always identifiable and have repeatable timing.

A standard technique to synchronise a communication channel is to use a phase lock loop, which would slowly adjust the clock of the receiver to match the transmitter. The synchronisation pulse as described in this disclosure has two significant advantages over relying on a phase lock loop synchronised communication link: it allows a greater range of processors or FPGA devices to be used controlling the gate drive - many cheaper parts do not have an applicable PLL. In addition, it means each packet of data sent to the gate drive is self-contained and does not affect subsequent packets - this is important for data security - especially to ensure that extreme noise does not affect sequential packets. Thus, the technique described later of requiring two sequential gate drive high requests adds significant robustness.

A PLL would allow more data transfer per packet. Extra data bits inside the packet stream would also allow this, but at the expense of a longer latency - and latency is crucial for a gate drive, hence it is paired down to a minimum. The overall frequency could be higher - it was chosen to match the existing MMC requirements of 5us. Were that not the case, it could be as fast as a 1us packet length or even shorter - this would likely be less efficient and less robust though.

### Data security - gate turn on

Regarding data security, the data from the Controller 110 to the Gate Drive 210 comprises solely of gate on or off information, which is of critical importance - crucially a false On must not be permitted. It is this false On event that is focused on later. Currently there is no provision for other data to the Gate Drive.

A significant data security feature is to require two "1" data bits in quick succession to force the Gate Drive signal to be high, and only one for it to be low. In addition, this produces a default dead time of 5us. To demonstrate this, Table 1 below shows an example of control signals from controller 110 -> Gate drive 210, and gives the resultant IGBT gate voltages:

| | | | | | | | |
|---|---|---|---|---|---|---|---|
| 0 | 0 | 0 | 1 | 0 | 0 | 0 | 1 |
| -10V | -10V | -10V | -10V | -10V | -10V | -10V | -10V |

**Table 1: Example of control signals from controller to gate drive and resultant IGBT gate voltages**

| | | | | | | |
|---|---|---|---|---|---|---|
| 1 | 1 | 0 | 1 | 1 | 0 | 0 |
| +15V | +15V | -10V | -10V | +15V | -10V | -10V |

### Data Back

The data back from the Gate Drive 210 to the controller 110 is in contrast low bandwidth data, and of lower importance. The low bandwidth data back of 1 bit per 5us requires its own packet structure, synchronisation, bit stuffing to avoid synchronization misidentification, and error checking. Data back is likely to comprise of the transistor on-state voltage, and the temperature of the transistor. The available hardware data back bitrate is 200kbit/s in an exemplary implementation, and it is envisaged that measurements must be transmitted every ms - which is likely to be 32kbit/s + overheads.

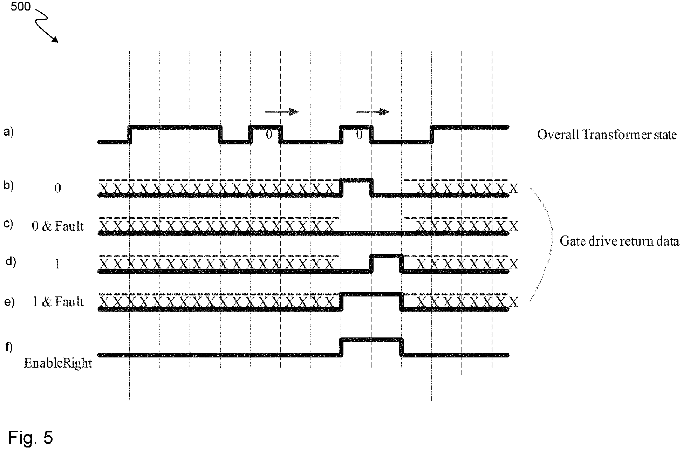

Fig. 5 shows another timing diagram 500 illustrating exemplary timing waveforms of a specific implementation of the gate driver arrangement 100.

### Fault flag

It is a common requirement for a gate drive to send fault information back to its controller - e.g., if the gate drive loses power, or if an IGBT is shorted out.

Fault information back can involve the Gate Drive driving its 0 and 1 bit slot high (or low) - this gives poor transformer utilisation - acceptable in fault as this is a low power state as the gate drive is turned off to protect the IGBT. Alone this information does not discriminate fault versus lack of gate drive power, as this will result in both bit slots in undefined states. This fault information can be complemented by using the payload data as "power and datalink ok" information, and can be interpreted from the payload data, as this is confirmed correct by error checking.

This technique is shown in Figure 5 where waveform a) illustrates overall transformer state and waveforms b), c), d), e) illustrate gate drive return data in the cases of 0 (waveform b), 0 & Fault (waveform c), 1 (waveform d) and 1 & Fault (waveform e). Waveform f) shows EnableRight signal which corresponds to TXEn signal output of gate drive circuit 210 in Figure 1. Note that waveforms in lines (c) and (e) would be classed as invalid data and would violate the 50% duty cycle requirement so could only be driven like that for the short term.

An alternative is to add an extra bit to the transformer protocol, just for this purpose. This requires a higher transformer bandwidth, which is achievable, and more CPU processing. It would still require correctly interpreted packets to indicate that power and communications are good.

The fault status may be embedded into the existing packet structure. As every data bit takes 5us instead of 100ns over fibre optics, the latency for a 50 bit packet will be 250us. As a deviation from the existing protocol, fault data can be inserted in multiple points along the packet structure to improve latency.

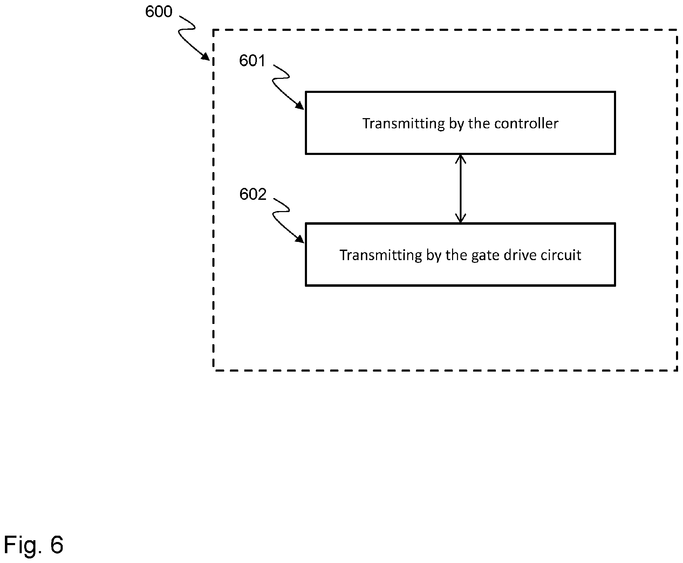

Fig. 6 shows a schematic diagram illustrating a method 600 for operating a gate driver arrangement according to the disclosure.

The method 600 may be used for operating a gate driver arrangement, e.g., a gate driver arrangement 100 as described above with respect to Figures 1 to 5. Such gate driver arrangement 100 comprises: a controller 110; and a gate drive circuit 210, wherein a transformer T1 is electrically arranged between the controller 110 and the gate drive circuit 210 which transformer T1 is galvanically separating the controller 110 from the gate drive circuit 210 as described above with respect to Figure 1.

The method 600 comprises: transmitting 601, by the controller 110, an electrical power signal 301 to the gate drive circuit 210 via the transformer T1 within a first time interval 313, e.g. as described above with respect to Figures 1 to 5.

The method 600 comprises: transmitting 602, by the gate drive circuit 210, a data signal to the controller 110 via the transformer T1 within a second time interval 312, wherein the data signal contains data, and wherein the first time interval 313 and the second time interval 312 do not overlap, e.g. as described above with respect to Figures 1 to 5.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

### LISTING OF REFERENCE SIGNS

- 100: gate driver arrangement
- T1: transformer
- 101: primary side of transformer
- 201: secondary side of transformer
- 105: isolation barrier
- 110: controller, central controller
- 120: first switch control circuit
- 220: second switch control circuit
- 121: RX terminal of controller
- 122: power terminal, e.g. 24V
- 130: cable, e.g. twisted pair or others
- 301: electrical power signal, transformer signal
- 310: synchronization pulse
- 311: third time interval
- 312: second time interval
- 313: first time interval
- C1: first capacitor
- C2: second capacitor
- SW1: first switch
- SW2: second switch
- SW3: third switch
- SW4: fourth switch
- 210: gate drive circuit
- U1: transistor, IGBT
- 211: gate of transistor
- 222: power terminal
- D3: first rectifier diode
- D4: second rectifier diode
- 200: timing diagram
- 300: timing diagram
- 400: timing diagram
- 500: timing diagram
- 600: method for operating gate driver arrangement
- 601: first method step
- 602: second method step

## Claims

1. A gate driver arrangement (100) comprising:
a controller (110);
a gate drive circuit (210) for driving a gate (211) of a transistor (U1); and
a transformer (T1) being electrically arranged between the controller (110) and the gate drive circuit (210), the transformer (T1) being configured for galvanically separating the controller (110) from the gate drive circuit (210);
wherein the controller (110) is configured to transmit an electrical power signal (301) to the gate drive circuit (210) via the transformer (T1) within a first time interval (313);
and
wherein the gate drive circuit (210) is configured to transmit a data signal to the controller (110) via the transformer (T1) within a second time interval (312), wherein the data signal contains data, and wherein the first time interval (313) and the second time interval (312) do not overlap.

2. The gate driver arrangement (100) of claim 1,
wherein the data indicates an operation status of the gate drive circuit (210).

3. The gate driver arrangement (100) of claim 1 or 2,
wherein the controller (110) is configured to transmit a control signal to the gate drive circuit (210) within the first time interval (313), in particular within a third time interval (311) which is within the first time interval (313).

4. The gate driver arrangement (100) of claim 3,
wherein the gate drive circuit (210) is configured to operate according to the received control signal.

5. The gate driver arrangement (100) of claim 3 or 4,
wherein the controller (110) is configured to use the electric power signal (301) as a carrier of the control signal, in particular to modulate the electrical power signal (301) with the control signal.

6. The gate driver arrangement (100) of any of claims 3 to 5,
wherein the gate drive circuit (210) is configured to retrieve the control signal, in particular to retrieve the control signal from the received electrical power signal or to demodulate the received electrical power signal to obtain the control signal.

7. The gate driver arrangement (100) of any of the preceding claims, wherein the gate driver arrangement (100) is used to drive a single transistor, in particular a transistor being part of a half-bridge-converter or a full-bridge converter.

8. The gate driver arrangement (100) of claim 7,
wherein the bridge converter comprises the transistor (U1) with the gate (211), wherein the transistor (U1) is configured to form a power switch;
wherein the gate drive circuit (210) is configured to apply a gate drive voltage to the gate (211) of the transistor (U1) in order to switch the transistor (U1) into a conducting state; and
wherein the gate drive voltage is based on the electrical power signal received from the controller (110).

9. The gate driver arrangement (100) of claim 8,
wherein the data signal comprises a status of the transistor (U1) including any faults detected and/or a measurement signal about a state of the transistor (U1), in particular a voltage and/or a temperature of the transistor (U1).

10. The gate driver arrangement (100) of any of the preceding claims, comprising:
first and second switches (SW1, SW2);
a first switch control circuit (120) for controlling switching of the first and second switches (SW1, SW2) by the controller (110);
third and fourth switches (SW3, SW4); and
a second switch control circuit (220) for controlling switching of the third and fourth switches (SW3, SW4) by the gate drive circuit (210);
wherein the first and second switch control circuits (120, 220) are configured to enable the transmission of the electrical power signal (301) to the gate drive circuit (210) via the transformer (T1) by alternately switching the first and second switches (SW1, SW2) while simultaneously keeping open the third and fourth switches (SW3, SW4).

11. The gate driver arrangement (100) of claim 10,
wherein the first and second switch control circuits (120, 220) are configured to enable the transmission of the data signal to the controller (110) via the transformer (T1) by opening the first and second switches (SW1, SW2) and selectively activating the third and fourth switches (SW3, SW4).

12. The gate driver arrangement (100) of any of the preceding claims,
wherein the controller (110) is configured to transmit a synchronization pulse (310) to the gate drive circuit (210), the synchronization pulse synchronizing the gate drive circuit (210) to transmit the data signal to the controller (110) via the transformer (T1) within the second time interval.

13. The gate driver arrangement (100) of any of the preceding claims,
wherein an electrical signal transmitted via the transformer (T1) has a duty cycle between 48% and 52%, preferably 50% duty cycle.

14. The gate driver arrangement (100) of any of the preceding claims, comprising:
two rectifier diodes (D3, D4) configured to rectify a voltage received by the transformer (T1) for the transmission of the power signal to the gate drive circuit (210).

15. The gate driver arrangement (100) of any of the preceding claims, comprising:
an electrically conducting connection (130) connecting the controller (110) and the transformer (T1), in particular a twisted-pair cable,
wherein the controller (110) is configured to transmit the electrical power signal (301) over the electrically conducting connection (130), and
wherein the gate drive circuit (210) is configured to transmit the data signal to the controller (110) over the electrically conducting connection (130).

16. A method (600) for operating a gate driver arrangement (100), the gate driver arrangement (100) comprising: a controller (110); and a gate drive circuit (210), wherein a transformer (T1) is electrically arranged between the controller (110) and the gate drive circuit (210), the transformer (T1) galvanically separating the controller (110) from the gate drive circuit (210), the method comprising:
transmitting (601), by the controller (110), an electrical power signal to the gate drive circuit (210) via the transformer (T1) within a first time interval (313); and
transmitting (602), by the gate drive circuit (210), a data signal to the controller (110) via the transformer (T1) within a second time interval (312), wherein the data signal contains data, and wherein the first time interval and the second time interval do not overlap.

17. A Modular Multilevel Converter, MMC, comprising:
a plurality of gate driver arrangements (100) according to any one of claims 1 to 15, the plurality of gate driver arrangements (100) being electrically arranged in parallel or in series.
